# EUROPEAN PATENT APPLICATION

(11) **EP 4 407 693 A1**
(43) Date of publication of application: **31.07.2024**
(21) Application number: 23769430.2
(22) Date of filing: 10.01.2023
(51) Int. Cl.: H01L 29/78

(54) **SEMICONDUCTOR DEVICE AND PREPARATION METHOD THEREFOR, INTEGRATED CIRCUIT, AND ELECTRONIC DEVICE**

(30) Priority: 16.03.2022 CN 202210260056
(71) Applicant: Huawei Digital Power Technologies Co., Ltd., Shenzhen, Guangdong 518043 (CN)
(72) Inventor: NING, Runtao, Shenzhen, Guangdong 518043 (CN); YANG, Wentao, Shenzhen, Guangdong 518043 (CN); XU, Gaochao, Shenzhen, Guangdong 518043 (CN); HE, Linrong, Shenzhen, Guangdong 518043 (CN); HUANG, Kangrong, Shenzhen, Guangdong 518043 (CN)
(74) Representative: Gill Jennings & Every LLP
(86) International application number: PCT/CN2023/071647
(87) International publication number: WO 2023/173919

(57) **Abstract**

This application provides a semiconductor device and a preparation method thereof, an integrated circuit, and an electronic device. The semiconductor device includes a drain, a substrate, an epitaxial layer, and a semiconductor layer. The semiconductor layer includes a source region located on a side that is at the semiconductor layer and that is away from the epitaxial layer. A trench extending to the epitaxial layer is disposed on a side that is of the source region and that is away from the epitaxial layer. A gate, an electrode plate, a first shield gate, and a second shield gate are disposed in the trench. The electrode plate is located between the first shield gate and the second shield gate. The trench is further filled with an oxidized layer structure. The first shield gate and the second shield gate are separately spaced from the electrode plate to form electrode plate capacitance. A first electrode is electrically connected to the electrode plate, and a second electrode is electrically connected to the shield gate structure. The first electrode is one of the source region, the drain, and the gate, the second electrode is one of the source region, the drain, and the gate, and the first electrode is different from the second electrode. The electrode plate capacitance can change output capacitance, Miller capacitance, or input capacitance to adjust a capacitance value and optimize performance of the semiconductor device.

## Description

### CROSS-REFERENCE TO RELATED APPLICATIONS

This application claims priority to Chinese Patent Application No. 202210260056.5, filed with the China National Intellectual Property Administration on March 16, 2022 and entitled "SEMICONDUCTOR DEVICE AND PREPARATION METHOD THEREOF, INTEGRATED CIRCUIT, AND ELECTRONIC DEVICE", which is incorporated herein by reference in its entirety.

### TECHNICAL FIELD

This application relates to the field of semiconductor technologies, and in particular, to a semiconductor device and a preparation method thereof, an integrated circuit, and an electronic device.

### BACKGROUND

A metal-oxide-semiconductor field-effect transistor (metal-oxide-semiconductor field-effect transistor, MOSFET) is widely used in the field of power electronics switches because of its fast switching speed and low driving loss. A shield gate MOSFET is of a structure in which a shield gate trench (shield gate trench, SGT) is introduced into a conventional trench MOSFET. Because the shield gate MOSFET has charge coupling effect, electric field distribution of the conventional MOSFET may be changed from a triangle to an approximate rectangle. In addition, doping concentration of a drift region may be increased by implementing charge balance, thereby reducing on-resistance. Therefore, the shield gate MOSFET may be widely used in low-voltage power devices.

However, because a depletion layer expands excessively quickly after a region between trenches is pinched off, output capacitance Coss and Miller capacitance Crss that are of the shield gate MOSFET decrease excessively quickly under action of a high voltage. When the shield gate MOSFET is cut off at a high speed, a cut-off stress exceeding a breakdown voltage is generated. Consequently, this reduces reliability of the shield gate MOSFET, and limits application of the shield gate MOSFET in the field of high speed switching.

### SUMMARY

This application provides a semiconductor device and a preparation method thereof, an integrated circuit, and an electronic device, to adjust capacitance in a fabrication process of the semiconductor device. In this way, a capacitance value required by the semiconductor device is obtained, so that performance of the semiconductor device is optimized.

According to a first aspect, this application provides a semiconductor device. The semiconductor device includes a substrate, an epitaxial layer, a semiconductor layer, a drain, and a trench. Specifically, the epitaxial layer is disposed on a side of the substrate, and the drain is disposed on a side that is of the substrate and that is away from the epitaxial layer. The semiconductor layer is disposed on a side that is at the epitaxial layer and that is away from the substrate. The semiconductor layer includes a source region. The source region is located on a side that is at the semiconductor layer and that is away from the epitaxial layer. An opening of the trench is disposed on a surface of a side that is of the source region and that is away from the epitaxial layer, and extends towards the substrate to the epitaxial layer.

A gate, an electrode plate, and a shield gate structure are disposed in the trench. Specifically, the shield gate structure includes a first shield gate and a second shield gate, the electrode plate is disposed between the first shield gate and the second shield gate, and the gate is disposed on a side that is of the trench and that is away from the substrate, and is located between the shield gate structure and an inner wall of the trench. The trench is further filled with an oxidized layer structure, the electrode plate and the shield gate structure are spaced, and electrode plate capacitance is formed by using the oxidized layer structure. A first electrode is electrically connected to the electrode plate, and a second electrode is electrically connected to the shield gate structure. The first electrode is one of the source region, the drain, and the gate, the second electrode is one of the source region, the drain, and the gate, and the first electrode is different from the second electrode.

The electrode plate capacitance can separately adjust output capacitance, Miller capacitance, or input capacitance by using the foregoing structure. In a process of fabricating the semiconductor device, a value of the electrode plate capacitance may be adjusted to adjust the capacitance of the semiconductor device. In this way, a turn-off stress of the semiconductor device is reduced, and performance of the semiconductor device is optimized. Therefore, in an application scenario of a circuit topology, for example, a resonant circuit, that has a specific requirement on a capacitance value, different capacitance of the semiconductor device can be effectively matched, thereby improving system efficiency. In addition, a structure of the semiconductor device does not increase an area of a chip and an area of an integrated circuit, and does not affect another parameter of the semiconductor device. Therefore, integration of the circuit can be improved more effectively, and fabrication costs can be reduced.

In some technical solutions, the oxidized layer structure may be provided with a contact hole, and the contact hole extends to the epitaxial layer. The electrode plate may be electrically connected to the epitaxial layer through the contact hole. The semiconductor device may further include a source metal layer. The source metal layer is disposed on the side that is at the semiconductor layer and that is away from the epitaxial layer, and the source region and the shield gate structure are separately electrically connected to the source metal layer. The electrode plate capacitance may be electrically connected to the source region and the drain, and may increase an overlapping area between the source and the drain that are of the semiconductor device, thereby increasing the output capacitance and improving a non-linear feature of the output capacitance.

In some other technical solutions, the oxidized layer structure may be provided with a contact hole, and the contact hole extends to the epitaxial layer. The electrode plate is in electrical contact with the epitaxial layer through the contact hole. The semiconductor device may further include an insulation layer. The insulation layer is disposed on the side that is at the semiconductor layer and that is away from the epitaxial layer. A metal connecting wire is disposed on a side that is at the insulation layer and that is away from the semiconductor layer. The metal connecting wire connects the gate and the shield gate structure, to enable the gate to be electrically connected to the shield gate structure. The electrode plate capacitance may be electrically connected to the gate and the drain, and may increase an overlapping area between the gate and the drain that are of the semiconductor device, thereby increasing the Miller capacitance and improving a non-linear feature of the Miller capacitance.

In some other technical solutions, the semiconductor device may further include an insulation layer, a source metal layer, and a metal connecting wire. The insulation layer is disposed on the side that is at the semiconductor layer and that is away from the epitaxial layer. The source metal layer and the metal connecting wire are disposed on a side that is at the insulation layer and that is away from the semiconductor layer. The source metal layer and the metal connecting wire are spaced. The metal connecting wire connects the gate and the shield gate structure, to enable the gate to be electrically connected to the shield gate structure. The source metal layer is electrically connected to the source region, the insulation layer is provided with a first via, and the source metal layer is electrically connected to the shield gate structure through the first via. The electrode plate capacitance may be electrically connected to the gate and the source region, and may increase an overlapping area between the gate and the source that are of the semiconductor device, thereby increasing the input capacitance and improving a non-linear feature of the input capacitance.

To facilitate setting of an electric field of the electrode plate capacitance, the electrode plate, the first shield gate, and the second shield gate may be disposed in parallel, so that the electric field of the electrode plate capacitance is a uniform electric field.

A value of the electrode plate capacitance may alternatively be changed by changing an overlapping area between the electrode plate and the first shield gate, and an overlapping area between the gate and the second shield gate. For example, the electrode plate, the first shield gate, and the second shield gate are all plate-shaped, and projection of the electrode plate in a direction perpendicular to the electrode plate separately overlaps the first shield gate and the second shield gate.

In the technical solution of this application, the gate may include a first gate and a second gate, the first gate is disposed on a side that is of the first shield gate and that is away from the electrode plate, and the second gate is disposed on a side that is of the second shield gate and that is away from the electrode plate.

Specific types of the electrode plate, the first shield gate, and the second shield gate are not limited. For example, the types of the electrode plate, the first shield gate, and the second shield gate may be the same. The electrode plate may be a P-type shield electrode plate, and the first shield gate and the second shield gate may be P-type shield gates; or the electrode plate may be an N-type shield electrode plate, and the first shield gate and the second shield gate may be N-type shield gates. Alternatively, the types of the electrode plate, the first shield gate, and the second shield gate may be different. The electrode plate may be a P-type shield electrode plate, and the first shield gate and the second shield gate may be N-type shield gates; or the electrode plate may be an N-type shield electrode plate, and the first shield gate and the second shield gate may be P-type shield gates.

In addition, specific materials of the electrode plate, the first shield gate, and the second shield gate are not limited. For example, the electrode plate may be a polysilicon electrode plate, and the first shield gate and the second shield gate may be polysilicon shield gates.

According to a second aspect, this application further provides an integrated circuit. The integrated circuit includes a circuit board and the semiconductor device according to the first aspect, where the semiconductor device is disposed on the circuit board.

Capacitance of the semiconductor device can be adjusted by using the foregoing structure, so that a turn-off stress of the semiconductor device is low, and performance of the semiconductor device is good. Therefore, the semiconductor device can be applied to an application scenario of a circuit topology that has a specific requirement on a capacitance value, thereby improving system efficiency. In addition, a structure of the semiconductor device does not increase an area of the integrated circuit, and does not affect another parameter of the semiconductor device. Therefore, integration of the integrated circuit can be improved more effectively, and fabrication costs can be reduced.

According to a third aspect, this application further provides an electronic device. The electronic device includes a housing and the integrated circuit according to the second aspect. The integrated circuit is disposed in the housing.

Capacitance of a semiconductor device can be adjusted by using the foregoing structure, so that a turn-off stress of the semiconductor device is low, and performance of the semiconductor device is good. Therefore, the electronic device can work in an application scenario of a circuit topology that has a specific requirement on a capacitance value, thereby improving work efficiency. In addition, the integrated circuit has a high degree of integration. This facilitates miniaturization of the electronic device, and fabrication costs of the electronic device are low.

According to a fourth aspect, this application further provides a method for preparing the semiconductor device according to the first aspect. The method includes:
fabricating an epitaxial layer on a surface of a side of a substrate;
fabricating a trench on a surface of a side that is at the epitaxial layer and that is away from the substrate; and
fabricating, by using a first process, a shield gate structure, an oxidized layer structure, an electrode plate, a gate, a semiconductor layer, and a drain, to enable a first electrode to be electrically connected to the electrode plate, and a second electrode to be electrically connected to the shield gate structure.

In the foregoing preparation process, a value of electrode plate capacitance may be adjusted to adjust capacitance of the semiconductor device. In this way, a turn-off stress of the semiconductor device is reduced, and performance of the semiconductor device is optimized. Therefore, the fabricated semiconductor device may be applied to a circuit topology, for example, a resonant circuit, that has a specific requirement on a capacitance value. In this way, different capacitance of the semiconductor device can be effectively matched, thereby improving system efficiency. In addition, a structure of the semiconductor device does not increase an area of a chip and an area of an integrated circuit, and does not affect another parameter of the semiconductor device. Therefore, integration of the circuit can be improved more effectively, and fabrication costs can be reduced.

### BRIEF DESCRIPTION OF DRAWINGS

FIG. 1 is a schematic diagram of a structure of a semiconductor device according to an embodiment of this application;
FIG. 2 is a schematic diagram of an equivalent capacitance network of the semiconductor device in FIG. 1;
FIG. 3 is a schematic diagram of another structure of a semiconductor device according to an embodiment of this application;
FIG. 4 is a schematic diagram of an equivalent capacitance network of the semiconductor device in FIG. 3;
FIG. 5 is a schematic diagram of another structure of a semiconductor device according to an embodiment of this application;
FIG. 6 is a schematic diagram of an equivalent capacitance network of the semiconductor device in FIG. 5;
FIG. 7 is a schematic flowchart of a method for preparing a semiconductor device according to an embodiment of this application;
FIG. 8 is a schematic diagram of a fabrication process of the semiconductor device in FIG. 1;
FIG. 9 is a schematic diagram of a fabrication process of the semiconductor device in FIG. 3; and
FIG. 10 is a schematic diagram of a fabrication process of the semiconductor device in FIG. 5.

Signs of the accompanying drawings:
10: semiconductor device; 11: substrate;
12: epitaxial layer; 13: semiconductor layer;
14: drain; 15: trench;
16: gate; 17: electrode plate;
18: shield gate structure; 19: oxidized layer structure;
21: source metal layer; 22: insulation layer;
131: source region; 161: first gate;
162: second gate; 181: first shield gate;
182: second shield gate; 191: contact hole;
221: first via; and 222: second via.

### DESCRIPTION OF EMBODIMENTS

To make the objectives, technical solutions, and advantages of this application clearer, the following further describes this application in detail with reference to the accompanying drawings.

Reference to "an embodiment", "some embodiments", or the like described in this specification means that one or more embodiments of this application include a specific feature, structure, or characteristic described with reference to embodiments. Therefore, statements such as "in an embodiment", "in another embodiment", "in some embodiments", "in some other embodiments", and "in other embodiments", that appear at different places in this specification do not necessarily mean referring to a same embodiment, instead, they mean "one or more but not all of embodiments", unless otherwise specifically emphasized. Terms "include", "comprise", "have", and their variants all mean "include but are not limited to", unless otherwise specifically emphasized.

Before a semiconductor device is fabricated, a specific structure of the semiconductor device is usually designed based on an application scenario, and then the semiconductor device is fabricated based on the designed structure. However, in actual application, problems may occur in application of the finished semiconductor device fabricated based on the design.

For example, for a shield gate MOSFET, although on-resistance can be reduced by using a shield gate trench structure, due to a structural limitation of the shield gate trench structure, output capacitance Coss and Miller capacitance Crss change excessively quickly under action of a high voltage, resulting in various problems in the shield gate MOSFET. In addition, when a discharge capacity of a turn-off loop is strong, if the output capacitance Coss, the Miller capacitance Crss, or the input capacitance Ciss is excessively small, a turn-off stress of the shield gate MOSFET is excessively large, and even exceeds a breakdown voltage of the shield gate MOSFET. As a result, the shield gate MOSFET is damaged. Therefore, magnitude of the output capacitance Coss, the Miller capacitance Crss, or the input capacitance Ciss affects magnitude of the turn-off stress of the shield gate MOSFET.

However, in a process of fabricating the shield gate MOSFET, when a device platform and the design are determined, values of the output capacitance Coss, the Miller capacitance Crss, and the input capacitance Ciss are basically determined. It is difficult to adjust the structure based on problems that occur in actual application. Only structural adjustments can be made to the design of the device structure. This greatly reduces costs and efficiency of fabricating the device.

Therefore, this application provides a semiconductor device and a preparation method thereof, an integrated circuit, and an electronic device, to adjust capacitance in a fabrication process of the semiconductor device. In this way, a capacitance value required by the semiconductor device is obtained, so that performance of the semiconductor device is optimized.

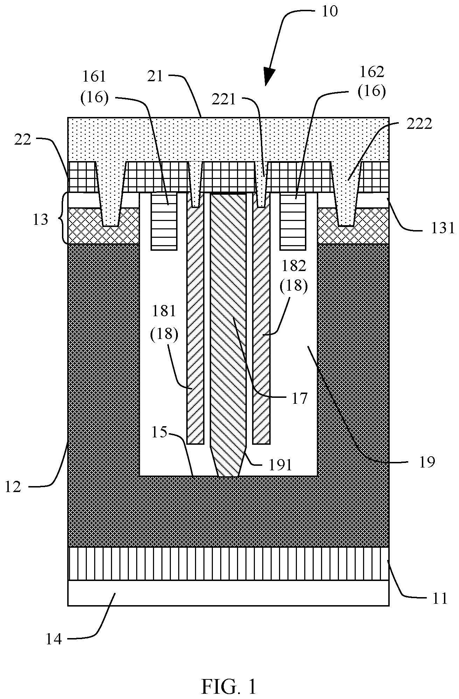

FIG. 1 is a schematic diagram of a structure of a semiconductor device according to an embodiment of this application. As shown in FIG. 1, the semiconductor device 10 includes a substrate 11. An epitaxial layer 12 and a semiconductor layer 13 are disposed on one side of the substrate 11, and a drain 14 is disposed on the other side of the substrate 11. Specifically, the epitaxial layer 12 is located between the substrate 11 and the semiconductor layer 13. The semiconductor layer 13 includes a source region 131. The source region 131 is located on a side that is at the semiconductor layer 13 and that is away from the epitaxial layer 12.

The semiconductor layer 13 is further provided with a trench 15. An opening of the trench 15 is located on a surface of a side that is of the source region 131 and that is away from the epitaxial layer 12. The trench 15 extends to the epitaxial layer 12 in a direction close to the substrate 11 (a vertical downward direction in FIG. 1). In other words, the trench 15 penetrates the semiconductor layer 13. It should be noted that a size of the opening of the trench 15 may not be specifically limited. In addition, an extension depth (the vertical direction in FIG. 1) of the trench 15 at the epitaxial layer 12 is not specifically limited. A gate 16, an electrode plate 17, and a shield gate structure 18 are disposed in the trench 15. The shield gate structure 18 includes a first shield gate 181 and a second shield gate 182. The first shield gate 181 and the second shield gate 182 are disposed on two sides of the electrode plate 17, and are spaced from the electrode plate 17. The gate 16 is disposed between the shield gate structure 18 and an inner wall of the trench 15, and is located on a side that is of the trench 15 and that is away from the substrate 11. In addition, the trench 15 is further provided with an oxidized layer structure 19. The oxidized layer structure 19 is filled between the shield gate structure 18 and the inner wall of the trench 15, between the shield gate structure 18 and the electrode plate 17, between the shield gate structure 18 and the gate 16, and between the gate 16 and the inner wall of the trench 15.

In the foregoing semiconductor device 10, the shield gate structure 18 and the electrode plate 17 may be spaced by using the oxidized layer structure 19, and electrode plate capacitance is formed. One of the source region 131, the gate 16, and the drain 14 is a first electrode, and one of the source region 131, the gate 16, and the drain 14 is a second electrode, and the first electrode is different from the second electrode. The electrode plate 17 may be electrically connected to the first electrode, and the shield gate structure 18 may be electrically connected to the second electrode. To be specific, the source region 131 and the drain 14 may be separately electrically connected to the electrode plate capacitance. Alternatively, the gate 16 and the drain 14 may be separately electrically connected to the electrode plate capacitance. Alternatively, the gate 16 and the source region 131 may be separately electrically connected to the electrode plate capacitance. Output capacitance Coss, Miller capacitance Crss, or input capacitance Ciss may be separately adjusted by using the foregoing different structures. In addition, because a value of the electrode plate capacitance is affected by the shield gate structure 18 and the electrode plate 17, in a process of fabricating the semiconductor device 10, a size and a position of the electrode plate 17 and a distance between the electrode plate 17 and the shield gate structure 18 may be adjusted. Therefore, the value of the electrode plate capacitance may be adjusted to adjust the capacitance of the semiconductor device 10. In this way, a turn-off stress of the semiconductor device 10 is reduced, and performance of the semiconductor device 10 is optimized.

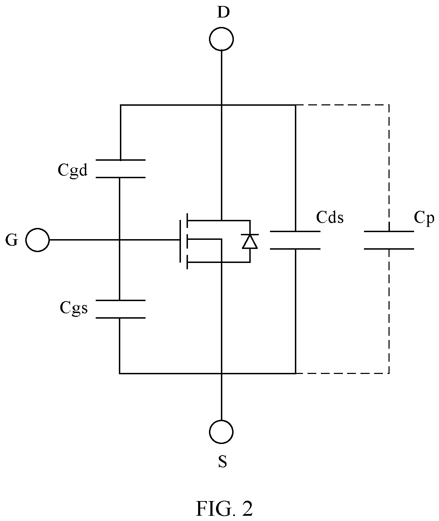

Still refer to FIG. 1. In some embodiments of this application, the electrode plate capacitance may be electrically connected to the source region 131 and the drain 14. Specifically, the semiconductor device 10 further includes a source metal layer 21. The source metal layer 21 is disposed on the side that is at the semiconductor layer 13 and that is away from the epitaxial layer 12. The source metal layer 21 is connected to the source region 131 and the shield gate structure 18, to enable the source region 131 to be electrically connected to the shield gate structure 18 to form a source. In this way, the electrode plate capacitance is electrically connected to the source region 131. The oxidized layer structure 19 is provided with a contact hole 191. The contact hole 191 extends to the epitaxial layer 12, to enable the electrode plate 17 to be electrically connected to the epitaxial layer 12 through the contact hole 191. In this way, the electrode plate capacitance is electrically connected to the drain 14. FIG. 2 is a schematic diagram of an equivalent capacitance network of the semiconductor device in FIG. 1. As shown in FIG. 2, electrode plate capacitance Cp is added between the source region 131 and the drain 14. An overlapping area between the source and the drain 14 that are of the semiconductor device 10 may be increased without affecting other electrical features such as a breakdown voltage and on-resistance that are of the semiconductor device 10, thereby increasing the output capacitance Coss and improving a non-linear feature of the output capacitance Coss. It should be noted that, in this embodiment, the output capacitance Coss includes Cds and the electrode plate capacitance Cp that are shown in FIG. 2. In addition, a value of the electrode plate capacitance Cp is not affected by expansion of a depletion layer, so that a speed at which the output capacitance Coss decreases with a voltage can be reduced. In addition, the output capacitance Coss of the semiconductor device 10 may be changed by changing the value of the electrode plate capacitance Cp, thereby improving a switching feature and a resonance feature that are of the semiconductor device 10.

In the foregoing embodiment, the source metal layer 21 may be directly disposed on a surface of the source region 131, so that the source metal layer 21 is electrically connected to the source region 131. Alternatively, another functional layer may be disposed between the source metal layer 21 and the source region 131. For example, in some embodiments, the semiconductor device 10 may further include an insulation layer 22 disposed between the semiconductor layer 13 and the source metal layer 21. The insulation layer 22 is provided with a first via 221 and a second via 222. The first via 221 may be disposed on a surface of a side that is at the insulation layer 22 that is away from the semiconductor layer 13, and extends to the shield gate structure 18 in a direction towards the substrate 11. In other words, projection of the trench 15 in a direction perpendicular to the substrate 11 may cover projection of the first via 221 in the direction perpendicular to the substrate 11. The source metal layer 21 may be in contact with the shield gate structure 18 through the first via 221, so that the source metal layer 21 is electrically connected to the shield gate structure 18. The second via 222 may be disposed on the surface of the side that is at the insulation layer 22 that is away from the semiconductor layer 13, and extends to the source region 131 in the direction towards the substrate 11. In other words, projection of the source region 131 in the direction perpendicular to the substrate 11 may cover projection of the second via 222 in the direction perpendicular to the substrate 11. The source metal layer 21 may be in contact with the source region 131 through the second via 222, so that the source metal layer 21 is electrically connected to the source region 131.

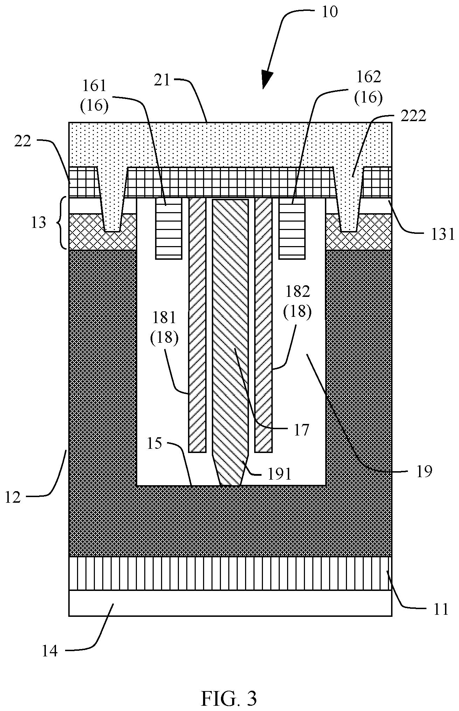

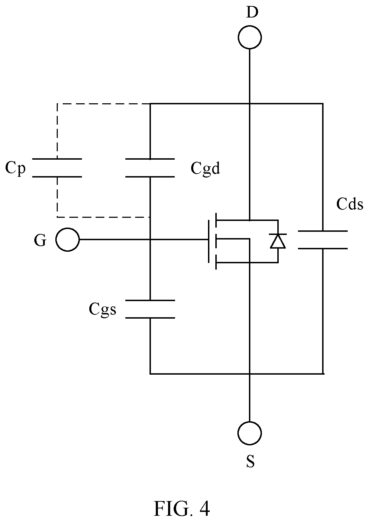

FIG. 3 is a schematic diagram of another structure of a semiconductor device according to an embodiment of this application. As shown in FIG. 3, in some other embodiments of this application, the electrode plate capacitance may be electrically connected to the gate 16 and the drain 14. Specifically, the oxidized layer structure 19 is provided with a contact hole 191. The contact hole 191 extends to the epitaxial layer 12, to enable the electrode plate 17 to be electrically connected to the epitaxial layer 12 through the contact hole 191. In this way, the electrode plate capacitance is electrically connected to the drain 14. The semiconductor device 10 further includes an insulation layer 22. The insulation layer 22 is disposed on the side that is at the semiconductor layer 13 and that is away from the epitaxial layer 12. A metal connecting wire (not shown in the figure) is disposed on a side that is at the insulation layer 22 and that is away from the semiconductor layer 13. The metal connecting wire connects the gate 16 and the shield gate structure 18, to enable the gate 16 to be electrically connected to the shield gate structure 18, so that the electrode plate capacitance is electrically connected to the gate 16. FIG. 4 is a schematic diagram of an equivalent capacitance network of the semiconductor device in FIG. 3. As shown in FIG. 4, electrode plate capacitance Cp is added between the gate 16 and the drain 14. An overlapping area between the gate 16 and the drain 14 that are of the semiconductor device 10 may be increased without affecting other electrical features such as a breakdown voltage and on-resistance that are of the semiconductor device 10, thereby increasing the Miller capacitance Crss and improving a non-linear feature of the Miller capacitance Crss. It should be noted that, in this embodiment, the Miller capacitance Crss includes Cgd and the electrode plate capacitance Cp that are shown in FIG. 4. In addition, a value of the electrode plate capacitance Cp is not affected by expansion of a depletion layer, so that a speed at which the Miller capacitance Crss decreases with a voltage can be reduced. In addition, the Miller capacitance Crss of the semiconductor device 10 may be changed by changing the value of the electrode plate capacitance Cp, thereby improving a switching feature and a resonance feature that are of the semiconductor device 10.

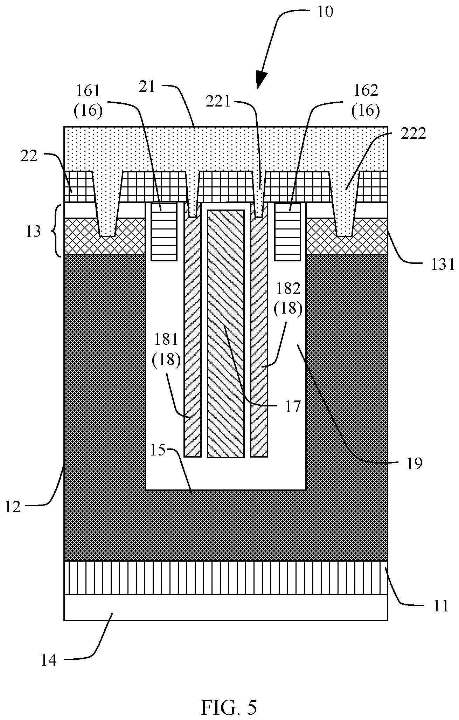

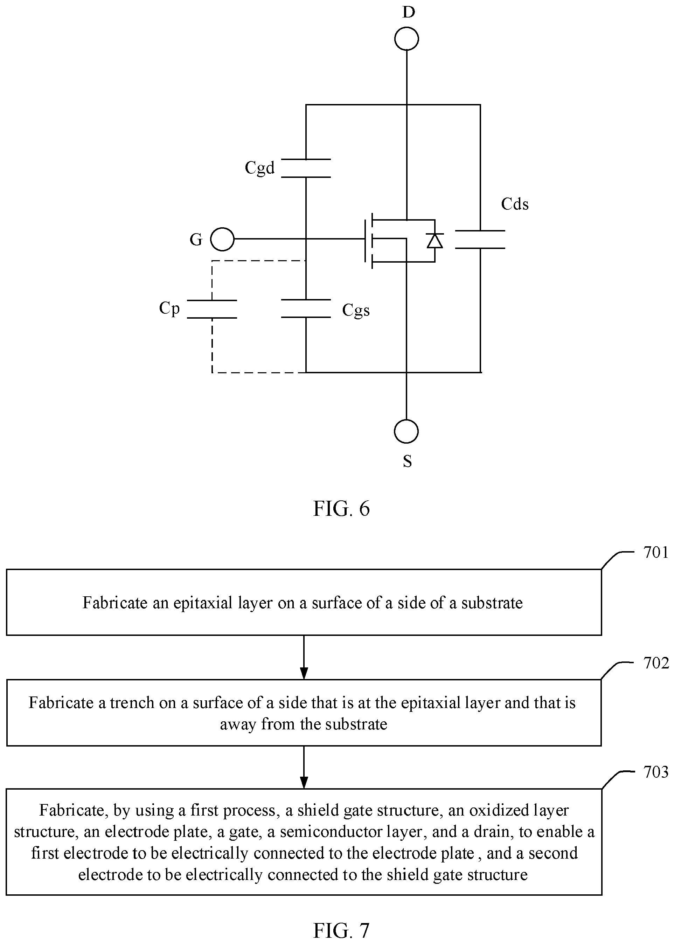

FIG. 5 is a schematic diagram of another structure of a semiconductor device according to an embodiment of this application. As shown in FIG. 5, in some other embodiments of this application, the electrode plate capacitance may be electrically connected to the gate 16 and the source region 131. Specifically, the semiconductor device 10 further includes an insulation layer 22, a source metal layer 21, and a metal connecting wire (not shown in the figure). The insulation layer 22 is disposed on the side that is at the semiconductor layer 13 and that is away from the epitaxial layer 12. Both the source metal layer 21 and the metal connecting wire are disposed on a side that is at the insulation layer 22 and that is away from the semiconductor layer 13, and the source metal layer 21 and the metal connecting wire are spaced. The metal connecting wire connects the gate 16 and the electrode plate 17, to enable the gate 16 to be electrically connected to the electrode plate 17, so that the electrode plate capacitance is electrically connected to the gate 16. The source metal layer 21 is connected to the source region 131 and the shield gate structure 18, to enable the source region 131 to be electrically connected to the shield gate structure 18 to form a source. In this way, the electrode plate capacitance is electrically connected to the source region 131. FIG. 6 is a schematic diagram of an equivalent capacitance network of the semiconductor device in FIG. 5. As shown in FIG. 6, electrode plate capacitance is added between the gate 16 and the source region 131. An overlapping area between the gate 16 and a source that are of the semiconductor device 10 may be increased without affecting other electrical features such as a breakdown voltage and on-resistance that are of the semiconductor device 10, thereby increasing the input capacitance Ciss and improving a non-linear feature of the input capacitance Ciss. It should be noted that, in this embodiment, the input capacitance Ciss includes Cgs and the electrode plate capacitance Cp that are shown in FIG. 6. In addition, a value of the electrode plate capacitance Cp is not affected by expansion of a depletion layer, so that a speed at which the input capacitance Ciss decreases with a voltage can be reduced. In addition, the input capacitance Ciss of the semiconductor device 10 may be changed by changing the value of the electrode plate capacitance Cp, thereby improving a switching feature and a resonance feature that are of the semiconductor device 10.

In this embodiment of this application, a size and a position that are of the electrode plate 17, a distance between the electrode plate 17 and the shield gate structure 18, and the like may be adjusted to adjust the electrode plate capacitance. For example, the electrode plate 17, the first shield gate 181, and the second shield gate 182 may be disposed in parallel, so that an electric field of the electrode plate capacitance is a uniform electric field. This facilitates adjustment of the value of the electrode plate capacitance. Certainly, the electrode plate 17 may alternatively be non-parallel to the first shield gate 181 and the second shield gate 182. This is not specifically limited in this application. In addition, the electrode plate 17, the first shield gate 181, and the second shield gate 182 may be of plate-like structures. Projection of the electrode plate 17 in a direction perpendicular to the first shield gate 181 may fall on the first shield gate 181, and the projection overlaps a surface of a side that is of the first shield gate 181 and that is close to the electrode plate 17; and/or projection of the electrode plate 17 in a direction perpendicular to the second shield gate 182 may also fall on the second shield gate 182, and the projection overlaps a surface of a side that is of the second shield gate 182 and that is close to the electrode plate 17. For example, in a specific embodiment, the electrode plate 17, the first shield gate 181, and the second shield gate 182 may be disposed in parallel, and sizes of the electrode plate 17, the first shield gate 181, and the second shield gate 182 may be the same. In other words, the projection of the electrode plate 17 on the first shield gate 181 may overlap the surface of the first shield gate 181, and the projection of the electrode plate 17 on the second shield gate 182 may overlap the surface of the second shield gate 182. In addition, a first distance between the electrode plate 17 and the first shield gate 181, and a second distance between the electrode plate 17 and the second shield gate 182 may be adjusted to change the value of the electrode plate capacitance. For example, a larger first distance and a larger second distance indicate a smaller value of the electrode plate capacitance. A smaller first distance and a smaller second distance indicate a larger value of the electrode plate capacitance. Therefore, in the process of fabricating the semiconductor device 10, the first distance and the second distance may be adjusted by controlling formation of the oxidized layer structure 19.

In addition, types of the electrode plate 17, the first shield gate 181, and the second shield gate 182 may be the same or different. This is not specifically limited in this application. For example, in some embodiments, the electrode plate 17 may be a P-type shield electrode plate, and the first shield gate 181 and the second shield gate 182 may be P-type shield gates. Alternatively, in some other embodiments, the electrode plate 17 may be an N-type shield electrode plate, and the first shield gate 181 and the second shield gate 182 may be N-type shield gates. Alternatively, in some other embodiments, the electrode plate 17 may be a P-type shield electrode plate, and the first shield gate 181 and the second shield gate 182 may be N-type shield gates. Alternatively, in some other embodiments, the electrode plate 17 may be an N-type shield electrode plate, and the first shield gate 181 and the second shield gate 182 may be P-type shield gates. In the foregoing embodiment, doping concentrations of the electrode plate 17 and the shield gate structure 18 may be the same, or may be different.

Certainly, the electrode plate 17 may be made of a same material or different materials as the first shield gate 181 and the second shield gate 182. For example, in a specific embodiment, the electrode plate 17, the first shield gate 181, and the second shield gate 182 may all use a polysilicon material, or may also use another conductive material such as tungsten or aluminum.

In this embodiment of this application, the gate 16 may include a first gate 161 and a second gate 162. The first gate 161 is disposed between the first shield gate 181 and the inner wall of the trench 15, and the second gate 162 is disposed between the second shield gate 182 and the inner wall of the trench 15. In other words, the first gate 161 is disposed on a side that is of the first shield gate 181 and that is away from the electrode plate 17, and the second gate 162 is disposed on a side that is of the second shield gate 182 and that is away from the electrode plate 17. When the electrode plate capacitance is added between the gate 16 and the drain 14, the first gate 161 may be electrically connected to the first shield gate 181 through the metal connecting wire, and the second gate 162 may be electrically connected to the second shield gate 182 through the metal connecting wire. In this way, the gate 16 is electrically connected to the electrode plate capacitance. Alternatively, when the electrode plate capacitance is added between the gate 16 and the source, the first electrode and the second electrode may be separately electrically connected to the electrode plate 17 through the metal connecting wire. In this way, the gate 16 is electrically connected to the electrode plate capacitance.

FIG. 7 is a schematic flowchart of a method for preparing a semiconductor device according to an embodiment of this application. As shown in FIG. 7, in this application, the method for fabricating the semiconductor device 10 may include the following steps.

Step S701: Fabricate an epitaxial layer on a surface of a side of a substrate.

Step S702: Fabricate a trench on a surface of a side that is at the epitaxial layer and that is away from the substrate.

Step S703: Fabricate, by using a first process, a shield gate structure, an oxidized layer structure, an electrode plate, a gate, a semiconductor layer, and a drain, to enable a first electrode to be electrically connected to the electrode plate, and a second electrode to be electrically connected to the shield gate structure.

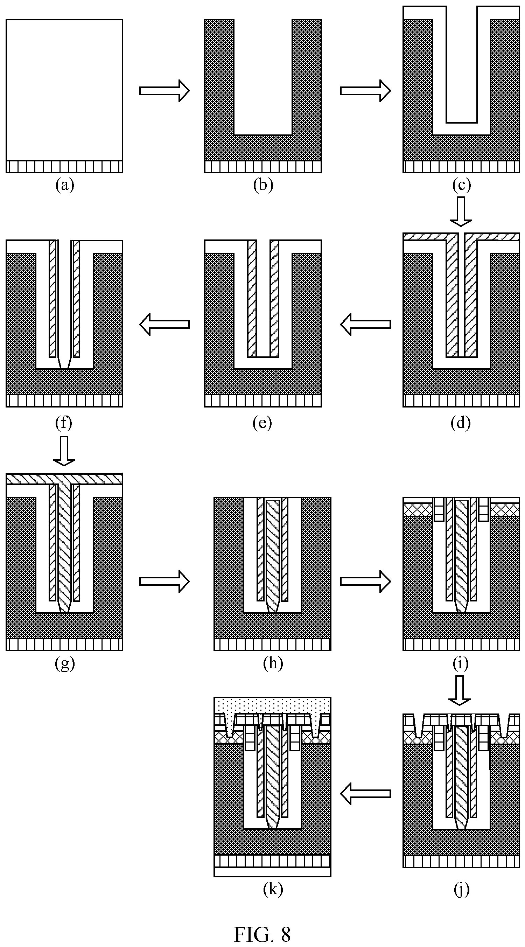

FIG. 8 is a schematic diagram of a fabrication process of the semiconductor device in FIG. 1. As shown in FIG. 8, in some embodiments of this application, electrode plate capacitance is added between a drain and a source that are of the semiconductor device. A process of fabricating the semiconductor device may specifically include the following steps.

Step S8(a): Fabricate an epitaxial layer on a surface of a side of a substrate.

Step S8(b): Fabricate a trench on a surface of a side that is at the epitaxial layer and that is away from the substrate.

Step S8(c): Fabricate first oxidized layers on a surface of an inner wall of the trench and the surface of the side that is at the epitaxial layer and that is away from the substrate.

Step S8(d): Deposit a shield gate material on an exposed surface at the first oxidized layer.

Step S8(e): Back etch the deposited shield gate material to form a first shield gate and a second shield gate.

After step S8(e) is completed, the shield gate at the bottom of the trench is etched. A shield gate structure of a side wall of the trench is retained to form the first shield gate and the second shield gate.

Step S8(f): Oxidize the first shield gate and the second shield gate to form second oxidized layers on surfaces on which the first shield gate and the second shield gate face each other, and etch the bottom of the first oxidized layer to form a contact hole.

In step S8(f), a specific value of the electrode plate capacitance may be adjusted by controlling sizes (for example, thickness, lengths, or heights) or positions (for example, positions relative to the first shield gate and the second shield gate) of the second oxidized layers, to adjust capacitance in the process of fabricating the semiconductor device.

Step S8(g): Deposit electrode plate materials on exposed surfaces of the first oxidized layers and the second oxidized layers, and enable the electrode plate materials to be contact with the epitaxial layer through the contact hole.

Step S8(h): Back etch the deposited electrode plate materials to form electrode plates; and perform surface planarization on the surface of the side that is at the epitaxial layer and that is away from the substrate, and a surface of a side that is of the trench and that is away from the substrate.

After step S8(h) is completed, the first oxidized layers and the second oxidized layers form an oxidized layer structure.

Step S8(i): Fabricate a gate, a semiconductor layer, and an insulation layer on the planarized surface.

In some other embodiments, the insulation layer may alternatively be omitted.

Step S8(j): Fabricate a first via and a second via on a surface of the insulation layer, so that the first via extends into the first shield gate and the second shield gate, and the second via extends into a source region.

Step S8(k): Form a source metal layer on a surface of a side that is of the insulation layer and that is away from the substrate, so that the source metal layer is in contact with the first shield gate and the second shield gate through the first via, and is in contact with the source region through the second via; and form a drain on a surface of a side that is of the substrate and that is away from the epitaxial layer.

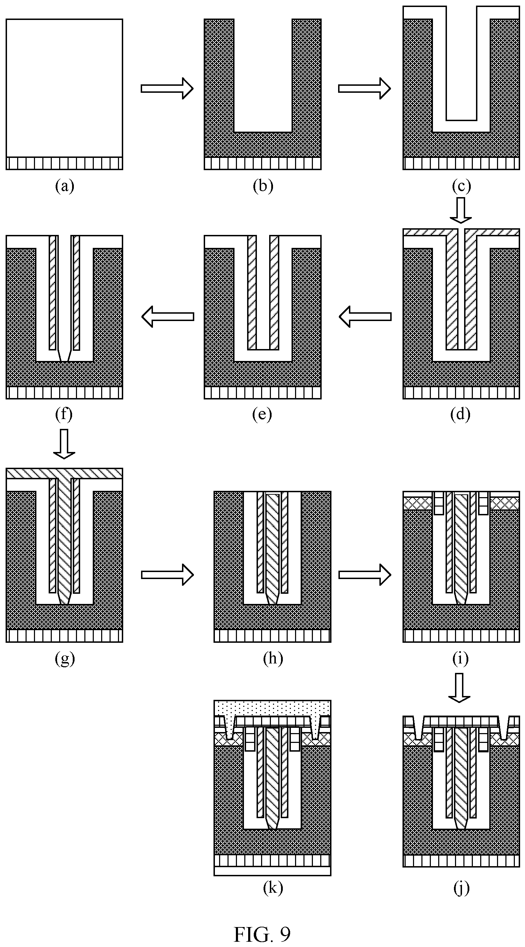

FIG. 9 is a schematic diagram of a fabrication process of the semiconductor device in FIG. 3. As shown in FIG. 9, in some other embodiments of this application, electrode plate capacitance is added between a drain and a gate that are of the semiconductor device. A process of fabricating the semiconductor device may specifically include the following steps.

Step S9(a) to step S9(i) are the same as step S8(a) to step S8(i). Details are not described herein again.

Step S9(j): Fabricate a second via on a surface of an insulation layer, so that the second via extends into a source region; and fabricate a metal connecting wire on the surface of the insulation layer, where the metal connecting wire connects the gate and a first shield gate, and connects the gate and a second shield gate.

Step S9(k): Form a source metal layer on a surface of a side that is of the insulation layer and that is away from a substrate, so that the source metal layer is in contact with the source region through the second via; and form the drain on a surface of a side that is of the substrate and that is away from an epitaxial layer.

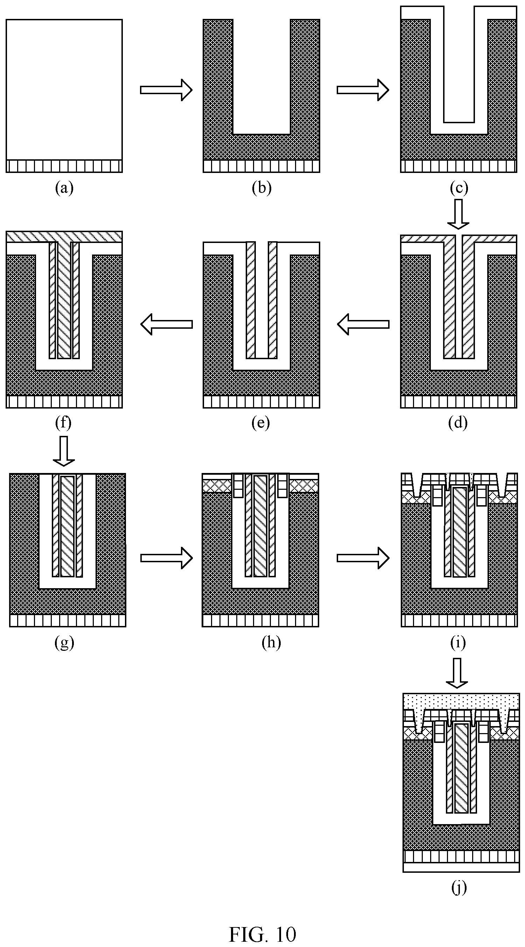

FIG. 10 is a schematic diagram of a fabrication process of the semiconductor device in FIG. 5. As shown in FIG. 10, in some other embodiments of this application, electrode plate capacitance is added between a source and a gate that are of the semiconductor device. A process of fabricating the semiconductor device may specifically include the following steps.

Step S 10(a) to step S 10(e) are the same as step S8(a) to step S8(e). Details are not described herein again.

Step S10(f): Back etch a deposited shield gate material to form a first shield gate and a second shield gate; oxidize the first shield gate and the second shield gate to form second oxidized layers on surfaces on which the first shield gate and the second shield gate face each other; and deposit electrode plate materials on exposed surfaces of first oxidized layers and second oxidized layers.

In step S10(f), a specific value of the electrode plate capacitance may be adjusted by controlling sizes (for example, thickness, lengths, or heights) or positions (for example, positions relative to the first shield gate and the second shield gate) of the second oxidized layers, to adjust capacitance in the process of fabricating the semiconductor device.

Step S10(g): Back etch the deposited electrode plate materials to form electrode plates; and perform surface planarization on a surface of a side that is at an epitaxial layer and that is away from a substrate, and a surface of a side that is of a trench and that is away from the substrate.

Step S 10(h): Fabricate a gate, a semiconductor layer, and an insulation layer on the planarized surface.

In some other embodiments, the insulation layer may alternatively be omitted.

Step S10(i): Fabricate a first via and a second via on a surface of the insulation layer, so that the first via extends into the first shield gate and the second shield gate, and the second via extends into a source region; and fabricate a metal connecting wire on a surface of the insulation layer, where the metal connecting wire connects the gate and the electrode plate.

Step S10(j): Form a source metal layer on a surface of a side that is of the insulation layer and that is away from the substrate, so that the source metal layer is in contact with the source region through the second via; and form a drain on a surface of a side that is of the substrate and that is away from the epitaxial layer.

Based on a same invention concept, this application further provides an integrated circuit. The integrated circuit includes a circuit board and the semiconductor device in any one of the foregoing embodiments. The semiconductor device is disposed on the foregoing circuit board. A turn-off stress of the semiconductor device is low, and performance of the semiconductor device is good. Therefore, the semiconductor device can be applied to an application scenario of a circuit topology that has a specific requirement on a capacitance value, thereby improving system efficiency. In addition, a structure of the semiconductor device does not increase an area of the integrated circuit, and does not affect another parameter of the semiconductor device. Therefore, integration of the integrated circuit can be improved more effectively, and fabrication costs can be reduced.

Based on a same invention concept, this application further provides an electronic device. The electronic device includes a housing and the foregoing integrated circuit, and the integrated circuit is disposed in the housing. Specifically, the foregoing integrated circuit may be disposed inside or on a surface of the housing. This is not limited in this application. Capacitance of a semiconductor device can be adjusted, so that a turn-off stress of the semiconductor device is low, and performance of the semiconductor device is good. Therefore, the electronic device can work in an application scenario of a circuit topology that has a specific requirement on a capacitance value, thereby improving work efficiency. In addition, the integrated circuit has a high degree of integration. This facilitates miniaturization of the electronic device, and fabrication costs of the electronic device are low.

Terms used in the foregoing embodiments are merely for a purpose of describing specific embodiments, but are not intended to limit this application. Terms "one", "a" and "this" of singular forms used in this specification and the appended claims of this application are also intended to include expressions such as "one or more", unless otherwise specified in the context clearly.

The foregoing description is merely a specific implementation of this application, but is not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising:
a substrate;
an epitaxial layer, wherein the epitaxial layer is disposed on a side of the substrate;
a semiconductor layer, wherein the semiconductor layer is disposed on a side that is at the epitaxial layer and that is away from the substrate, the semiconductor layer comprises a source region, and the source region is disposed on a side that is at the semiconductor layer and that is away from the epitaxial layer;
a drain, wherein the drain is disposed on a side that is of the substrate and that is away from the epitaxial layer;
a trench, wherein an opening of the trench is disposed on a surface of a side that is of the source region and that is away from the epitaxial layer, and the trench extends to the epitaxial layer; a gate, an electrode plate, and a shield gate structure are disposed in the trench, the shield gate structure comprises a first shield gate and a second shield gate, the electrode plate is disposed between the first shield gate and the second shield gate, and the gate is disposed on a side that is of the trench and that is away from the substrate, and is located between the shield gate structure and an inner wall of the trench; and the trench is further filled with an oxidized layer structure, the electrode plate and the shield gate structure are spaced, and electrode plate capacitance is formed by using the oxidized layer structure; and
a first electrode, electrically connected to the electrode plate, and a second electrode, electrically connected to the shield gate structure, wherein the first electrode is one of the source region, the drain, and the gate, the second electrode is one of the source region, the drain, and the gate, and the first electrode is different from the second electrode.

2. The semiconductor device according to claim 1, wherein the oxidized layer structure is provided with a contact hole, the contact hole extends to the epitaxial layer, and the electrode plate is electrically connected to the epitaxial layer through the contact hole; and
the semiconductor device further comprises a source metal layer, wherein the source metal layer is disposed on the side that is at the semiconductor layer and that is away from the epitaxial layer, and the source region and the shield gate structure are separately electrically connected to the source metal layer.

3. The semiconductor device according to claim 1, wherein the oxidized layer structure is provided with a contact hole, the contact hole extends to the epitaxial layer, and the electrode plate is in electrical contact with the epitaxial layer through the contact hole; and
the semiconductor device further comprises an insulation layer, the insulation layer is disposed on the side that is at the semiconductor layer and that is away from the epitaxial layer, a metal connecting wire is disposed on a side that is at the insulation layer and that is away from the semiconductor layer, and the metal connecting wire connects the gate and the shield gate structure, to enable the gate to be electrically connected to the shield gate structure.

4. The semiconductor device according to claim 1, wherein the semiconductor device further comprises an insulation layer, a source metal layer, and a metal connecting wire, the insulation layer is disposed on the side that is at the semiconductor layer and that is away from the epitaxial layer, the source metal layer and the metal connecting wire are disposed on a side that is at the insulation layer and that is away from the semiconductor layer, and the source metal layer and the metal connecting wire are spaced;
the metal connecting wire connects the gate and the shield gate structure, to enable the gate to be electrically connected to the shield gate structure; and
the source metal layer is electrically connected to the source region, the insulation layer is provided with a first via, and the source metal layer is electrically connected to the shield gate structure through the first via.

5. The semiconductor device according to any one of claims 1 to 4, wherein the electrode plate, the first shield gate, and the second shield gate are disposed in parallel.

6. The semiconductor device according to claim 5, wherein the electrode plate, the first shield gate, and the second shield gate are all plate-shaped, and projection of the electrode plate in a direction perpendicular to the electrode plate separately overlaps the first shield gate and the second shield gate.

7. The semiconductor device according to any one of claims 1 to 6, wherein the gate comprises a first gate and a second gate, the first gate is disposed on a side that is of the first shield gate and that is away from the electrode plate, and the second gate is disposed on a side that is of the second shield gate and that is away from the electrode plate.

8. The semiconductor device according to any one of claims 1 to 7, wherein the electrode plate is a P-type shield electrode plate, and the first shield gate and the second shield gate are P-type shield gates; or the electrode plate is an N-type shield electrode plate, and the first shield gate and the second shield gate are N-type shield gates.

9. The semiconductor device according to any one of claims 1 to 8, wherein the electrode plate is a polysilicon electrode plate, and the first shield gate and the second shield gate are polysilicon shield gates.

10. An integrated circuit, comprising a circuit board and the semiconductor device according to any one of claims 1 to 9, wherein the semiconductor device is disposed on the circuit board.

11. An electronic device, comprising a housing and the integrated circuit according to claim 10, wherein the integrated circuit is disposed in the housing.

12. A method for preparing the semiconductor device according to any one of claims 1 to 9, comprising:
fabricating an epitaxial layer on a surface of a side of a substrate;
fabricating a trench on a surface of a side that is at the epitaxial layer and that is away from the substrate; and
fabricating, by using a first process, a shield gate structure, an oxidized layer structure, an electrode plate, a gate, a semiconductor layer, and a drain, to enable a first electrode to be electrically connected to the electrode plate, and a second electrode to be electrically connected to the shield gate structure.
